Europäisches Patentamt

European Patent Office

Office européen des brevets

(11) Numéro de publication : **0 006 779**
**B1**

(12) **FASCICULE DE BREVET EUROPÉEN**

(45) Date de publication du fascicule du brevet :
**19.05.82**

(51) Int. Cl.³ : **G 01 R 13/34,** G 01 R 13/32,
H 03 K 13/02, H 04 N 5/00

(21) Numéro de dépôt : 79400347.5

(22) Date de dépôt : 31.05.79

(54) **Dispositif de numérisation de signaux transitoires.**

(30) Priorité : 13.06.78 FR 7817621

(43) Date de publication de la demande :
09.01.80 (Bulletin 80/01)

(45) Mention de la délivrance du brevet :
19.05.82 Bulletin 82/20

(84) Etats contractants désignés :
CH DE GB IT NL

(56) Documents cités :
FR - A - 2 326 806
GB - A - 1 505 330
US - A - 3 958 210

REVIEW OF SCIENTIFIC INSTRUMENTS ; vol. 44,
nr. 6, juin 1973 ; pages 712-714, New York (US)
BALDIS : « High Speed Single Event Sampler »

(73) Titulaire : THOMSON-CSF
173, Boulevard Haussmann
F-75360 Paris Cedex 08 (FR)

(72) Inventeur : Bernet, Jean-Marie
"THOMSON-CSF" - SCPI 173, bld Haussmann
F-75360 Paris Cedex 08 (FR)
Inventeur : Lejeune, Gabriel
"THOMSON-CSF" - SCPI 173, bld Haussmann
F-75360 Paris Cedex 08 (FR)

(74) Mandataire : Eisenbeth, Jacques Pierre et al
THOMSON-CSF SCPI 173, Bld Haussmann
F-75360 Paris Cedex 08 (FR)

Imprimerie Jouve, 18, rue St-Denis, 75001 Paris, France

Dispositif de numérisation de signaux transitoires

La présente invention est relative à un dispositif de numérisation de signaux transitoires et s'applique plus particulièrement à de tels dispositifs qui travaillent sur un signal unique ou non répétitif. De tels dispositifs relèvent de façon préférentielle du domaine connu sous le nom d'électronique rapide.

Dans un dispositif de numérisation de signaux transitoires, on procède au prélèvement d'un certain nombre N d'échantillons à une cadence déterminée F, sur un signal unique ou non répétitif. Ces échantillons sont numérisés puis mis en mémoire, et les résultats sont ensuite exploités suivant les désirs de l'utilisateur. L'article de Baldis et al. « High Speed Single Event Sampler » dans la revue of Scientific Instruments vol. 44, n° 6, juin 1973, pages 712 à 714 décrit un tel dispositif de numérisation de signaux transitoires dans lequel on trouve six dispositifs principaux, un dispositif d'échantillonnage et de maintien, un multiplexeur, un convertisseur analogique-numérique, une mémoire à accès aléatoire, un circuit numérique d'horloge et une interface de sortie.

L'invention concerne le dispositif de numérisation qui comprend la mise en mémoire des signaux numérisés dans des dispositifs particuliers différents des circuits de maintien de l'art antérieur et qui échappent aux inconvénients des trois types principaux de numériseurs de signaux transitoires qui sont définis ci-dessous et à l'un desquels appartient précisément le dispositif de Baldis et al.

Un premier type est spécialement adapté à une numérisation effectuée à une cadence inférieure ou égale à une vingtaine de mégahertz. Un dispositif de ce premier type comprend essentiellement comme on l'a vu, commandés par une horloge, un dispositif d'échantillonnage comportant un dispositif de mémoire intermédiaire recevant le signal à traiter, un convertisseur analogique numérique série ou série parallèle, et une mémoire stockant les informations numérisées.

Ce dispositif présente une dynamique correcte, qui peut être supérieure ou égale à 8 bits et un nombre de point limité à la capacité de la mémoire.

Un deuxième type de numériseurs est capable de travailler à une cadence supérieure à 20 MHz.

Un tel numériseur ne diffère pas essentiellement du dispositif qui a été décrit précédemment si ce n'est dans l'organisation du convertisseur analogique numérique qui est constitué par une chaîne de comparateurs dont chacun est polarisé à une tension qui correspond à un niveau de quantification. Cette chaîne comprend ainsi autant de comparateurs moins 1 qu'il a de niveaux de quantification.

Un tel dispositif présente une dynamique limitée et un poids en composants important.

Un troisième type de numériseurs de l'art connu est celui comportant un oscilloscope à mémoire.

Dans ce cas le signal dès sa réception est inscrit en temps réel sur une mosaïque mémoire semblable à celle d'un oscilloscope. Un balayage lent du type télévision revide les cellules chargées à l'inscription créant de la sorte un signal vidéo numérisé à cadence lente.

Un tel dispositif présente l'avantage d'une cadence apparente d'échantillonnage élevée de l'ordre de ou supérieure à 1 GHz. Toutefois le nombre des points est limité à quelques centaines et des distorsions se font jour imputables aux non-linéarités du balayage.

La présente invention a ainsi pour but un dispositif numériseur relevant du premier type.

Suivant l'invention telle que définie dans la revendication principale, le dispositif de numérisation comprend une pluralité de portes d'échantillonnage rapide, disposées en parallèle, une pluralité de dispositifs à transfert de charge enregistrant les échantillons délivrés par les portes d'échantillonnage, un multiplexeur analogique connectant les sorties des dispositifs à transfert de charge à un convertisseur analogique numérique, un dispositif d'exploitation comprenant une mémoire enregistrant les signaux numérisés et une horloge contrôlant l'inscription et la lecture des échantillons.

D'autres avantages et caractéristiques de l'invention apparaîtront dans la description qui suit d'un exemple de réalisation donné à l'aide des figures qui représentent :

la figure 1 un diagramme schématique du dispositif suivant l'invention ;

la figure 2 un diagramme du dispositif d'entrée de la figure 1 ;

la figure 3 un diagramme détaillé d'un dispositif à transfert de charge, et

la figure 4 une série de courbes explicatives du fonctionnement du dispositif.

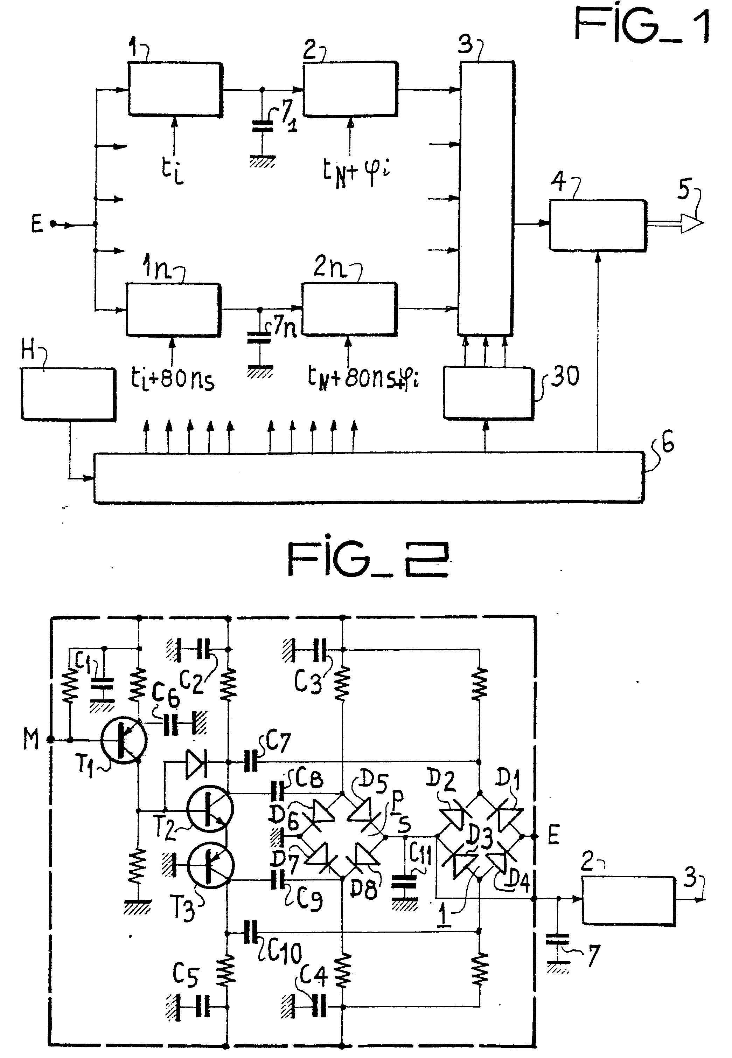

La figure 1 présente sous une forme schématique un dispositif de numérisation rapide conforme à l'invention.

L'entrée E où apparaît le signal à numériser est connectée à une ou plusieurs portes d'échantillonnage ultra-rapides $1_1$ à $1_n$ montées en parallèle. Chaque porte est connectée à un dispositif 2 à transfert de charges, dont les sorties sont connectées à un dispositif de multiplexage analogique 3. La sortie de ce multiplexeur est connectée à un convertisseur analogique-numérique 4 dont la sortie est connectée à un dispositif d'utilisation 5 qui n'est pas décrit comme ne faisant pas partie de l'invention mais qui comporte au moins une mémoire enregistrant les échantillons des signaux numérisés. Chacun des dispositifs énumérés est contrôlé par une horloge, en fait une horloge H dite de cadencement alimentant un distributeur d'impulsions d'horloge 6 qui répartit les impulsions d'horloge à la fréquence désirée aux différents dispositifs. En particulier, le distributeur 6 est connecté au multiplexeur 3 à travers un décodeur 30. L'utilisation d'un dispositif à transfert de charge, comme mémoire, est décrite dans le brevet GB-A-1 505 330, toutefois dans une application tout à fait différente et suivant une technique différente, dite à multi-niveaux.

En ce qui concerne le fonctionnement du dispositif suivant l'invention, le signal analogique apparaissant à l'entrée E est échantillonné par les portes ultra-rapides $1_1$ à $1_n$. Chaque porte par exemple prélève un échantillon toutes les 100 ns et l'instant de prélèvement d'une porte est décalé de 20 ns par rapport à celui de la porte adjacente. Ces circuits sont ainsi contrôlés par des impulsions d'horloge aux instants ti pour la première, ti + 20 ns pour la seconde, etc... Chaque échantillon est introduit dans les 100 ns qui suivent un prélèvement dans le dispositif à transfert de charge qui est associé. Un tel dispositif peut comporter une centaine de cellules ; il est destiné à stocker de façon temporaire les informations analogiques échantillonnées qui sont délivrées par les portes auxquelles il est connecté. L'inscription des échantillons dans les cellules se fait à une cadence (t) correspondant à une fréquence de l'ordre de 10 MHz dans l'exemple décrit.

Lorsque les dispositifs de transfert de charges (DTC) sont pleins, l'horloge change de cadence et passe par exemple à la cadence ($\varphi$) correspondant à une fréquence de 20 kHz. C'est à cette cadence ($\varphi$) que les informations issues des différents dispositifs à transfert de charge sont lues, mais avec un certain décalage d'un dispositif au suivant de l'ordre de 20 ns par exemple de sorte qu'elles sont appliquées pratiquement simultanément en parallèle au dispositif de multiplexage 3. Sur le diagramme de la figure 1 sont indiqués les instants ($\tau_N + \varphi_i$, etc) auxquels lesdites informations sont appliquées au multiplexeur 3. La sortie du multiplexeur est appliquée à un dispositif 4, de conversion analogique-numérique qui peut travailler à une cadence relativement lente, de l'ordre par exemple de 100 kHz donnée par le distributeur 6 et qui délivre alors un mot de 10 bits toutes les 10 microsecondes.

On notera que les valeurs numériques données ne le sont qu'à titre d'exemple. Le dispositif n'est pas modifié si les valeurs de fréquence d'horloge sont 50 MHz, 50 kHz par exemple.

En fait, le dispositif tel qu'il vient d'être décrit, constitue une carte imprimée de dimensions relativement modestes de l'ordre de 190 × 120 mm comportant jusqu'à cinq portes d'échantillonnage ultra-rapides. Une telle carte, actuellement se comporte donc comme un organe de numérisation du signal atteignant une cadence de l'ordre de 50 mégamots par seconde, susceptible de prélever 500 échantillons et de les numériser sur 10 bits ou 12 bits.

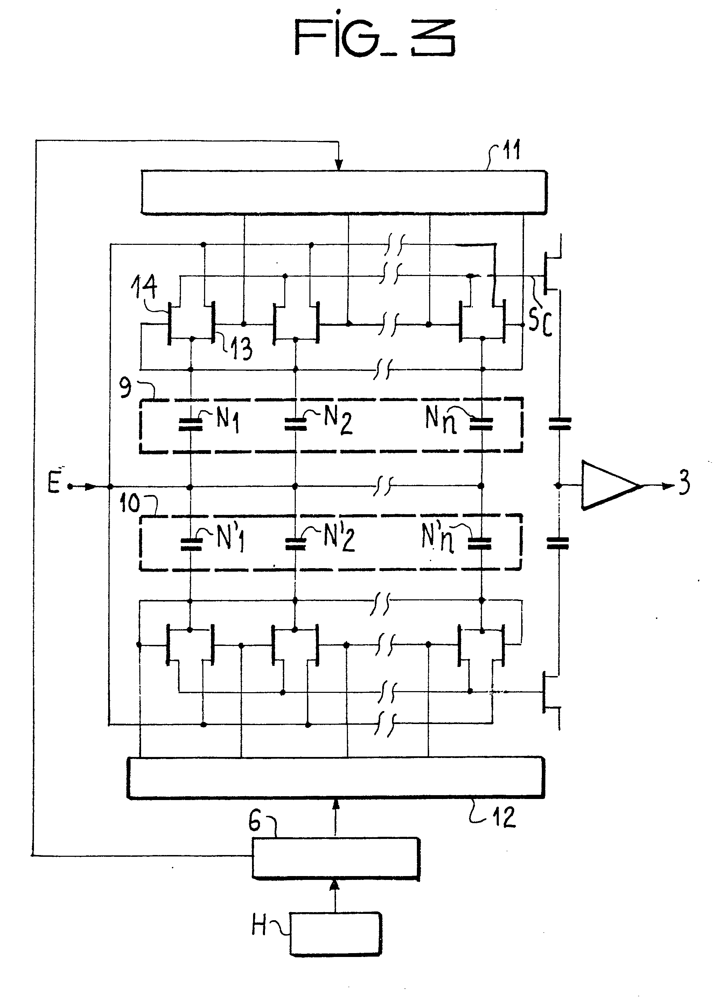

La figure 2 représente sous forme schématique, le dispositif d'entrée du dispositif à transfert de charge.

Le signal à enregistrer est appliqué à l'entrée E de la porte d'échantillonnage 1 dont les diodes D1 à D4 sont normalement bloquées et dont la sortie S est court-circuitée par un pont P constitué par des diodes D5 à D8. Ce pont est normalement conducteur.

Le signal de déclenchement de la prise d'échantillon au signal apparaissant à l'entrée, c'est-à-dire le signal issu de l'horloge de l'enregistreur, arrive en M sur la base d'un transistor T1. Les transistors T2 et T3, T2 ayant à sa base connectée au collecteur du transistor T1 et T3 ayant son émetteur connecté à l'émetteur de T2 et les deux transistors de plus étant de type complémentaire, sont amenés du blocage à la saturation, un créneau de tension positif apparaissant sur le collecteur du transistor T3 tandis qu'il apparaît négatif sur le collecteur du transistor T2. Ces créneaux de tension passant respectivement par les capacités C9 et C8 provoquent le blocage du pont P et partant, libèrent la sortie de la porte d'échantillonnage 1 reliée à un dispositif à transfert de charge 2 dont la capacité d'entrée 7 constitue la capacité de maintien de l'échantillon.

Ces mêmes créneaux de tension passent par les capacités de différenciation C7 et C10 et fournissent des impulsions étroites d'ouverture de la porte d'échantillonnage rapide 1. Pendant ce temps d'ouverture très bref, la capacité mémoire, constituée pour la plus grande part par la cellule activée du dispositif à transfert de charge 2 et pour le reste par une capacité fixe C11 tend à se charger à la valeur de la tension présente à l'entrée. Cette capacité C11 garde sa charge pendant un temps défini, de l'ordre dans l'exemple d'application décrit de 15 ns au bout duquel le pont P se remet à conduire. Au préalable la cellule du dispositif à transfert de charge a été isolée de la porte rapide. Cette conduction a pour effet de vider rapidement la capacité de maintien restante C11. De la sorte, dans un délai qui peut être qualifié de minimal, la porte d'échantillonnage considérée se retrouve dans son état initial et l'effet parasite de mémoire imputable à une tension de sortie dépendant de la valeur de l'échantillon précédent est annulé bien qu'en fait le rendement de la porte ne soit pas égal à 100 %.

Le dispositif de numérisation qui est un dispositif intégré à transfert de charges tel que représenté Fig. 3 par exemple comporte une suite N de capacités indépendantes N1 à Nn — N'1 à N'n, chacune d'entre elles étant reliée aux sorties des portes d'échantillonnage par l'intermédiaire d'un commutateur à transistor à effet de champ MOS 13 ; chacune des N capacités est, de la même façon, reliée à une sortie commune SC par l'intermédiaire d'un transistor à effet de champ 14. Chacun des commutateurs 13 est successivement activé par un compteur en anneau 11, 12 qui progresse sous le contrôle d'une horloge H avec un répartiteur 6. A chaque période d'horloge, une cellule est connectée sur l'entrée, tandis que la suivante l'est sur la sortie.

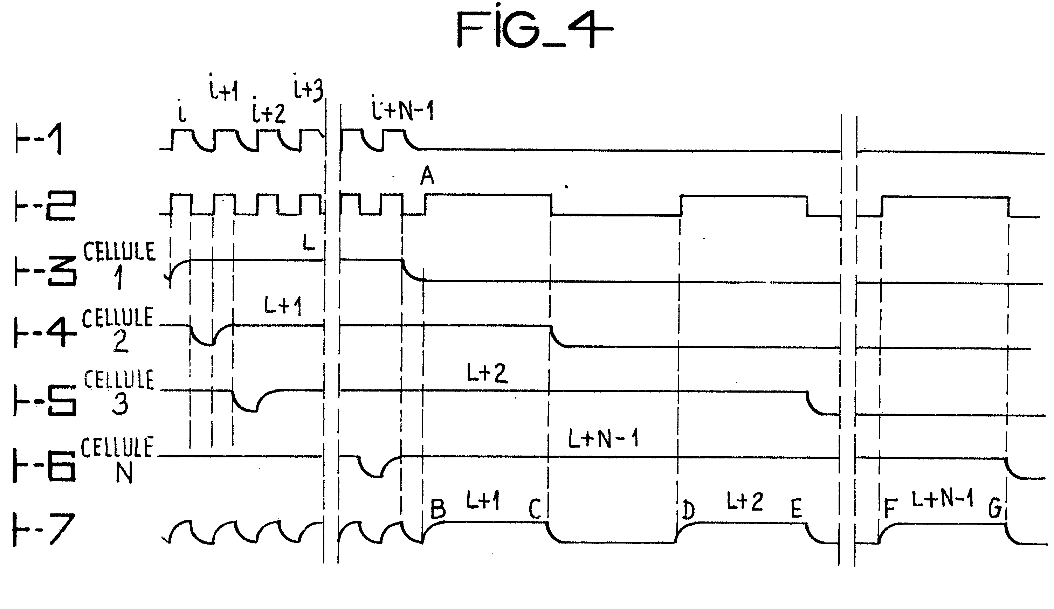

Le processus d'enregistrement et de numérisation est représenté sur le diagramme des temps de la figure 4.

On considère les échantillons de rang i, i + 1, i + 2, etc. issus de la porte d'échantillonnage rapide 1 de la figure 2 à la cadence de 10 MHz (figure 4-1) ; celle-ci fonctionne en permanence dans l'attente d'un ordre de déclenchement de la mesure.

Pendant 50 nanosecondes dans l'exemple décrit, la sortie de la porte est mise en relation avec la cellule capacitive correspondante qu'elle charge à la crête ; la différence de phase entre l'horloge du dispositif à transfert de charge (figure 4-2) et l'horloge d'échantillonnage est telle que la liaison est interrompue avant le retour à zéro de la sortie de la porte rapide ; simultanément à la charge de la première cellule considérée, la cellule suivante est mise en liaison avec la sortie du dispositif pour être lue.

Pendant les 50 nanosecondes suivantes, la cellule suivante est remise à zéro, c'est-à-dire que sa liaison avec la sortie est maintenue mais que celle-ci est mise à la masse, la mettant en mesure d'acquérir une nouvelle charge.

A la période d'horloge suivante, l'échantillon de rang $i + 1$ charge la cellule suivante, etc. Les courbes des figures 4-3 et 4-6 montrent comment les différents échantillons successifs chargent les différentes cellules.

Lorsque l'échantillon $i + N - 1$ a été introduit dans la dernière cellule N, l'échantillonnage rapide cesse et l'horloge du dispositif à transfert de charges est ralentie (instant A) la période devenant égale à 100 microsecondes par exemple. Pendant cette première demi-période lente, l'échantillon de rang $i + 1$ est numérisé (figure 4-7 partie B-C) par un convertisseur analogique numérique 4 à 12 bits qui peut être relativement lent (faible consommation, faible encombrement, faible coût) et mis en mémoire numérique. A la période suivante, l'échantillon de rang $i + 2$ est numérisé (partie DE de la figure 4-7) et ainsi de suite jusqu'à l'échantillon $i + N - 1$.

On notera que l'échantillon $i$ a été remis à zéro lors de l'acquisition de l'échantillon de rang $i + N - 1$ : le procédé ne permet donc d'enregistrer que $N - 1$ échantillons.

On pourra noter que le dispositif complet suivant l'invention peut comprendre plus d'un dispositif tel que celui qui a été décrit. Dans un exemple de réalisation le dispositif comprend 5 ensembles échantillonnage-nodule mémoire. Chaque ensemble fonctionne avec un décalage de temps de 20 ns par rapport au précédent, pendant l'enregistrement, et de 20 microsecondes pendant la phase de numérisation. Le prélèvement sur l'entrée signal n'ayant lieu que pendant moins d'une nanoseconde, une porte ne perturbe pas l'entrée de sa voisine.

La réalisation matérielle est faite sous forme de cartes qui, constituées avec des dispositifs mémoires intégrés à 100 cellules par exemple, réalisent la prise et la numérisation de 495 échantillons prélevés à la cadence maximale d'un échantillon toutes les 20 nanosecondes. Des 12 bits numérisés, 10 seulement sont réellement exploitables en raison du rapport signal maximal à bruit de la prise d'échantillon associée à la mise en mémoire.

Un dispositif de numérisation de transitoires suivant l'invention peut contenir jusqu'à dix cartes de numérisation ainsi définies ; les horloges de chaque carte sont décalées les unes par rapport aux autres de 20 ns/n, n étant le nombre de cartes. On obtient de la sorte avec dix cartes un échantillonnage au pas minimal de 2 ns et un nombre d'échantillons mémorisés égal à 4 950.

On a ainsi décrit un dispositif de numérisation de transitoires comprenant des portes d'échantillonnage rapide et des dispositifs à transfert de charges utilisés comme mémoires intermédiaires.

## Revendications

1. Dispositif de numérisation de signaux transitoires, comportant un dispositif d'échantillonnage des signaux à numériser, un convertisseur analogique-numérique (3) et un dispositif mémoire (5), caractérisé en ce qu'il comporte une pluralité de portes d'échantillonnage ultra-rapide disposées en parallèle $(1_1-1_n)$ auxquelles sont appliqués les signaux à numériser, une pluralité de dispositifs à transfert de charge $(2_1-2_n)$ comportant chacun une pluralité (N) de cellules enregistrant les échantillons délivrés par les portes d'échantillonnage, un multicomplexeur analogique (3) connectant les sorties des dispositifs à transfert de charge à un convertisseur analogique-numérique, un dispositif d'exploitation (5) comprenant une mémoire enregistrant les signaux ainsi numérisés et une horloge (H) contrôlant l'inscription des échantillons dans les cellules et leur lecture ultérieure à des fréquences différentes, l'inscription étant faite à cadence (t) rapide et les instants de prélèvement d'un échantillon du signal à numériser par les différentes portes étant décalés les uns par rapport aux autres d'une valeur déterminée et la lecture étant faite à une cadence (4) relativement lente et les échantillons lus à la sortie des différents dispositifs à transfert de charge étant appliqués quasi simultanément en parallèle au multiplexeur.

2. Dispositif de numérisation suivant la revendication 1, caractérisé en ce que la liaison entre la sortie d'une porte d'échantillonnage $(1_1-1_n)$ et l'entrée du dispositif à transfert de charges associé $(2_1-2_n)$ est capacitive, cette capacité $(7_1-7_n)$ consituant une capacité de maintien pour l'échantillon de signal transmis.

3. Dispositif de numérisation suivant l'une des revendications 1 et 2, caractérisé en ce que les dispositifs à transfert $(2_1-2_n)$ de charge sont des dispositifs intégrés comportant une suite (N) de capacités indépendantes, (N1 à Nn – N'1 à N'n) chacune d'entre elles étant connectée à l'entrée (E) et à la sortie (Sc) par un commutateur à transistor à effet de champ (13-14) contrôlé par un compteur en anneau (11-12).

4. Dispositif de numérisation suivant l'une des revendications 1, 2 et 3, caractérisé en ce qu'il se présente sous la forme d'au moins une carte imprimée de dimensions modestes de l'ordre de 190 × 120 mm comportant jusqu'à cinq portes

d'échantillonnage ($1_1$-$1_n$) et un nombre (N) de cellules à transfert de charge de l'ordre de la centaine.

5. Dispositif de numérisation suivant la revendication 4, caractérisé en ce qu'il comprend dix cartes imprimées avec chacune une horloge d'échantillonnage rapide décalée par rapport aux autres de chaque fois un temps déterminé faible de l'ordre de 20 ns divisé par le nombre de cartes, donnant un échantillonnage au pas minimal de 2 ns et un nombre d'échantillons mémorisés égal à 4 950.

## Claims

1. Digitizing device for transitory signals comprising a sampling device of signals to be digitized, a converter-analog-digital (3) and a storage device (5), characterized in that it comprises a plurality of ultra-rapid sampling gates arranged in parallel (1-$1_n$) to which the signals to be digitized are applied, a plurality of charge transfer devices, each comprising a plurality of cells registering the delivered sample by the sampling gates, an analog multiplexer (3) connecting the outputs of the charge transfer devices to a converter-analog-digital, an operation device (5) comprising a store registering the signals thus digitized, and a clock (H) checking the entry of the samples in the cells and their subsequent reading at different frequencies, with the entry being made at a rapid cadence and the moments of sample taking of the signal to be digitized by the different gates being shifted with respect to each other by a predetermined value and reading being made at relatively slow cadence and the samples read at the output of the different charge transfer devices supplied quasi-simultaneously in parallel to the multiplexer.

2. Digitizing device according to claim 1, characterized in that the link between the output of a sampling gate (1-$1_n$) and the input of the associated charge transfer device (2-$2_n$) is capacitive, with this capacitance constituting a maintaining capacitance for the sample of transmitted signals.

3. Digitizing device according to one of claims 1 and 2, characterized in that the charge transfer devices (2-$2_n$) are integrated devices comprising a sequence of independent capacitances (N1 to Nn-N'1 to N'n), each of which being connected to the input (E) and the output (Sc) by a field-effect transistor switch (13-14), controlled by a ring counter (11-12).

4. Digitizing device according to one of claims 1, 2 and 3, characterized in that it is in the form of at least one printed card of small size, about 190 × 120 mm, comprising up to 5 sampling gates (1-1n) and a plurality of charge transfer cells in the amount of about 100.

5. Digitizing device according to claim 4, characterized in that it comprises ten printed cards, with for each a rapid sampling clock, shifted with respect to others, each time by a short predetermined time in the order of 20 ns divided by the number of cards, giving a sampling at the minimal pace of 2 n, and a number of stored samples equal to 4 950.

## Ansprüche

1. Digitaldarstellungsvorrichtung für nicht ständige Signale, die eine Probenvorrichtung für die digital darzustellenden Signale einschliesst, einen Analog-Digital-Umsetzen (3) und eine Speichervorrichtung (5), dadurch gekennzeichnet, dass sie eine Mehrzahl von von sehr schellen Proben-Gattern, die parallel geschaltet sind (1-1n), einschliesst, auf welche die digital darzustellenden Signale übertragen werden, eine Mehrzahl von Ladungsübertragungsvorrichtungen deren jede eine Mehrzahl von Zellen zum Registrieren der gelieferten Proben durch die Probengatter aufweist, einen Analog-Multiplexer-(3), der die Ausgänge der Ladungsübertragungsvorrichtung mit einem Analog-Digital-Umsetzen verbindet, eine Betriebsvorrichtung (5), die einen Speicher einschliesst, der die so digital dargestellten Signale registriert, und einen Taktgeber (H) der die Registrierung der Proben in den Zellen prüft und ihr nachfolgendes Lesen bei verschiedenen Frequenzen, wobei die Registrierung in schnellen Schritten erfolgt und die Augenblicke des Probenehmens des digital darzustellenden Signals durch verschiedene Gatter verschoben werden im Verhältnis zueinander durch einen vorbestimmten Wert und das Lesen in verhältnismässig langsamen Schritten erfolgt und die Proben, die am Ausgang der verschiedenen Ladungsübertragungsvorrichtungen gelesen werden, praktisch gleichzeitig parallel dem Multiplexer zugeführt werden.

2. Digitaldarstellungsvorrichtung gemäss Anspruch 1, dadurch gekennzeichnet dass die Verbindung zwischen dem Ausgang des Probengatters (1-$1_n$) und dem Eingang der dazugehörigen Ladungsübertragungsvorrichtungen (2-$2_n$) kapazitiv ist, wobei diese Kapazität eine Aufrechterhaltungskapazität für die Probe der übertragenen Signale darstellt.

3. Digitaldarstellungsvorrichtung gemäss einem der Ansprüche 1 und 2, dadurch gekennzeichnet, dass die Ladungsübertragungsvorrichtungen (2-$2_n$) intergrierte Vorrichtungen darstellen, die eine Folge von unabhängigen Kapazitäten (N1 bis Nn-N'1 bis N'n) einschliessen, wobei eine jede mit dem Eingang (E) und dem Ausgang (Sc) durch einen Feld-Effekt-Transistor-Schalter (13-14) verbunden ist, der durch einen Ringzähler (11-12) kontrolliert wird.

4. Digitaldarstellungsvorrichtung gemäss einen der Ansprüche 1, 2 und 3, dadurch gekennzeichnet, dass sie die Form einer gedruckten Karte kleiner Grösse etwa 190 × 120 mm, hat, die bis zu 5 Probengatter (1-$1_n$) und eine Mehrzahl von etwa 100 Ladungsübertragungsvorrichtung Zellen einschliesst.

5. Digitaldarstellungsvorrichtung gemäss Anspruch 4, dadurch gekennezeichnet dass sie gedruckte Karten einschliesst, mit für eine jede einem schnellen Proben-Zeitgeber, im Verhältnis zu den anderen verschoben, jedesmal in einer kurzen vorbestimmten Zeit von 20 ns geteilt durch die Anzahl der Karten, wobei eine Probe im geringen Zeitraum von 2n gegeben wird, und eine Anzahl von gespeicherten Proben gleich 4 950.

0 006 779

FIG_1

FIG_2

# FIG_3

FIG_4